# EUROPÄISCHE PATENTSCHRIFT

(11) **EP 2 568 246 B1**
(45) Veröffentlichungstag und Bekanntmachung des Hinweises auf die Patenterteilung: **29.04.2015**
(21) Anmeldenummer: 12195506.6
(22) Anmeldetag: 13.02.2003
(51) Int. Cl.: F27D 5/00, C04B 35/64, H01L 41/273, H01L 41/083

(54) **Haltevorrichtung für keramisches Vielschichtbauelement**
Retaining device for ceramic multilayer component
Dispositif de retenue pour composant céramique multicouche

(30) Priorität: 13.02.2002 DE 10205877
(43) Veröffentlichungstag der Anmeldung: 13.03.2013
(62) Teilanmeldung aus: 03708027.2
(73) Patentinhaber: EPCOS AG, 81669 München (DE)
(72) Erfinder: Sedlmaier, Peter, 9113 Ruden (AT)
(74) Vertreter: Epping - Hermann - Fischer

(56) Entgegenhaltungen:
- EP-A- 0 452 718
- DE-B1- 2 542 083
- RU-C- 2 144 170
- US-A- 5 364 608
- US-A- 5 628 849
- PATENT ABSTRACTS OF JAPAN Bd. 2000, Nr. 2, 29. Februar 2000 (2000-02-29) -& JP 11, 304371, A, (MARUJU:KK), 5. November 1999 (1999-11-05)

## Beschreibung

Die Erfindung betrifft eine Haltevorrichtung zur Verwendung beim Sintern eines keramischen Vielschichtbauelements.

Aus der Druckschrift WO 01/45138 A2 ist ein Verfahren zur Herstellung eines piezoelektrischen Bauelements bekannt, das Innenelektroden aus Kupfer aufweist. Das Bauelement wird hergestellt durch Sintern in einer Sinteratmosphäre, die Sauerstoff enthält. Der benötigte Sauerstoffpartialdruck wird über ein Gasgleichgewicht eingestellt, das sich zwischen den Gasen Wasserstoff und Wasserdampf einstellt. Üblicherweise werden zur Herstellung des Piezoaktors Keramikmaterialien auf der Basis von Blei-Zirkon-Titanat verwendet. Es kommen darüber hinaus Haltevorrichtungen zum Halten von einer Vielzahl von ungesinterten Bauelementen in einem Sinterofen zum Einsatz, welche aus temperaturbeständigen Strukturkeramiken wie Alumina, Kordierit, Siliziumcarbid u. s. w. bestehen.

Um eine Oxidation der Kupferinnenelektroden zu verhindern, ist es bei dem bekannten Verfahren erforderlich, den Sauerstoffpartialdruck in einem sehr engen zulässigen Druckbereich einzustellen. Bei Unterschreitung des zulässigen Sauerstoffpartialdrucks wird die PZT-Keramik sehr leicht reduziert und dabei irreversibel geschädigt. Bei Überschreitung des zulässigen Sauerstoffpartialdrucks kommt es zur Oxidation und Schädigung der Kupferinnenelektroden. Das bekannte Verfahren hat den Nachteil, daß der durch das Wasserstoff/Wasserdampf-Gasgleichgewicht eingestellte Sauerstoffpartialdruck sehr leicht durch geringste Mengen an Sauerstoff aufnehmende beziehungsweise Sauerstoff abgebende Stoffe aus dem zulässigen Arbeitsbereich herausgeschoben werden kann. Beispielsweise können Stoffe wie Restkohlenstoff, Verunreinigungen in der Keramik oder auch das Abdampfen von Blei aus der Keramik zu einer Verschiebung des Sauerstoffpartialdrucks führen.

Dies kann den Effekt haben, daß auch bei bestmöglicher Einstellung der Gasatmosphäre während des Sinterns eine lokale Oxidation der Kupferinnenelektroden zu beobachten ist. Dies äußert sich in zwischen den Innenelektroden und dem Keramikmaterial eingelagerten Zwischenschichten oder Zwischenbereichen aus Kupferoxid, die im Schliffbild senkrecht zu den Innenelektroden makroskopisch sichtbar ist. Durch diese Zwischenschichten aus Kupferoxid werden die elektrischen Eigenschaften des piezoelektrischen Bauelements verschlechtert

US 5 628 849 A zeigt eine Haltevorrichtung für das Sintern keramischer Vielschichtbauelemente mit den Merkmalen des Oberbegriffs von Anspruch 1, nämlich einen Behälter für das Sintern von metallisierten Keramikbauteilen, mit Grundplatte (Behälterboden), Zwischenlagen 12 und 14 zwischen denen die zu sinternden Bauteile 25 angeordnet sind, und Deckel 20, und mit schmelzbaren Distanzelementen 16 zwischen den Zwischenlagen und 18 zwischen Deckel und Behälter, die z.B. aus Ag-Cu, oder Ag-Au-Ge gefertigt sind.

Auch EP 0 452 718 A und DE 25 42 083 B zeigen Haltevorrichtungen mit den konkreten Vorrichtungsmerkmalen des Oberbegriffs von Anspruch 1, insbesondere Kupfer- bzw. Kupferlegierungsbeschichtungen, die dem Korrosionschutz der Haltevorrichtung dienen.

Es ist Aufgabe der vorliegenden Erfindung, eine Haltevorrichtung anzugeben, die es auf einfache Art und Weise erlaubt, ein Verfahren zur Herstellung eines keramischen Vielschichtbauelements durchzuführen, bei dem der Sauerstoffgehalt der Sinteratmosphäre stabilisiert ist.

Diese Aufgabe wird gelöst durch eine Haltevorrichtung gemäß dem Patentanspruch 1. Vorteilhafte Ausgestaltungen der Erfindung sind Gegenstand der Unteransprüche.

Die erfindungsgemäße Haltevorrichtung findet Anwendung bei einem Verfahren zur Herstellung eines keramischen Vielschichtbauelements, wobei Verfahren und Vielschichtbauelement zwar nicht beansprucht, im Folgenden jedoch beschrieben werden.

Es wird ein Verfahren zur Herstellung eines keramischen Vielschichtbauelements beschrieben, wobei ein Grundkörper, der eine ungesinterte Keramik enthält und der wenigstens eine metallhaltige Innenelektrode aufweist, gesintert wird. Das Sintern erfolgt dabei in einer Sinteratmosphäre, üblicherweise in einem abgeschlossenen Sintervolumen. Innerhalb der Sinteratmosphäre ist ein Sinterhilfsmittel vorgesehen, das ein in der Sinteratmosphäre enthaltenes Gas binden und wieder abgeben kann.

Dieses Binden kann beispielsweise durch Physisorption oder auch Chemisorption erfolgen.

Das Vorsehen eines Sinterhilfsmittels in der Sinteratmosphäre hat den Vorteil, daß das Sinterhilfsmittel gewissermaßen als Puffer wirken kann, der eine überschüssige in der Sinteratmosphäre enthaltene Gaskomponente bindet und bei Unterschuß derselben Komponente diese wieder an die Sinteratmosphäre abgeben kann. Dadurch kann die Sinteratmosphäre bezüglich ihrer Gaszusammensetzung stabilisiert werden.

Es wird darüber hinaus ein Verfahren zur Herstellung eines keramischen Vielschichtbauelements beschrieben, wobei das Sinterhilfsmittel ein Metall enthält, dessen Redoxpotential wenigstens so groß ist wie das Redoxpotential des in den Innenelektroden enthaltenen Metalls.

Durch das Vorsehen eines metallhaltigen Sinterhilfsmittels in der Sinteratmosphäre während des Sinterns kann erreicht werden, daß das Sinterhilfsmittel, falls die Sinteratmosphäre so abgeändert wird, daß die Innenelektroden oxidiert würden, zunächst bevorzugt oxidiert wird. Dadurch kann eine Oxidation der Innenelektroden verhindert werden. Metalle, deren Redoxpotential kleiner ist als das Redoxpotential des in den Innenelektroden enthaltenen Metalls sind dafür weniger gut geeignet, da sie bei Sinteratmosphären, die eine Oxidation der edleren Innenelektroden gerade noch vermeiden, leicht oxidiert werden und dadurch beispielsweise Sauerstoff der Sinteratmosphäre ständig entziehen würden. Demgegenüber sind Metalle als Sinterhilfsmittel geeignet, deren Redoxpotential größer ist als das Redoxpotential des in den Innenelektroden enthaltenen Metalls und die mithin edler sind, als das Metall der Innenelektroden. Da das Sinterhilfsmittel für die Sinteratmosphäre frei zugänglich ist und da im Gegensatz dazu die Innenelektroden für die Sinteratmosphäre nicht frei zugänglich sind, weil im Innern des Grundkörpers angeordnet, wird im Falle einer von den Idealbedingungen abweichender Sinteratmosphäre trotz des größeren Redoxpotentials das Sinterhilfsmittel noch vor den Innenelektroden durch diese verändert. Die Innenelektroden bleiben dabei unverändert erhalten, was erwünscht ist.

Es wird darüber hinaus ein mit der erfindungsgemäßen Haltevorrichtung hergestelltes, keramisches Vielschichtbauelement beschrieben, das einen Grundkörper mit einer gesinterten Keramik aufweist. Der Grundkörper enthält wenigstens eine Innenelektrode, bei der wenigstens die Oberfläche metallhaltig ist. Die Innenelektrode enthält ein Metall, dessen Redoxpotential kleiner oder gleich dem Redoxpotential von Kupfer ist. Die Innenelektroden bzw. deren metallischen Oberflächen grenzen direkt an die gesinterte Keramik des Grundkörpers an. Eine Schicht oder Oberflächenbereiche mit oxidiertem Metall der Innenelektrode ist nicht vorhanden. Ein solches Vielschichtbauelement kann mit Hilfe der angegebenen Verfahren hergestellt werden. Es hat den Vorteil, daß aufgrund nicht vorhandenen Metalloxids zwischen den Innenelektroden und der gesinterten Keramik die elektrischen Eigenschaften des Vielschichtbauelements verbessert sind.

Es wird eine Haltevorrichtung angegeben, die zur Verwendung beim Sintern von keramischen Vielschichtbauelementen mit metallhaltigen Innenelektroden vorgesehen ist. Die Haltevorrichtung ist zur Aufnahme einer Vielzahl von ungesinterten Bauelementen geeignet. An der Oberfläche der Haltevorrichtung ist ein Material vorgesehen, das ein in der Sinteratmosphäre enthaltenes Gas binden und wieder abgeben kann.

Eine solche Haltevorrichtung hat den Vorteil, daß sie eine leichte Durchführung des beschriebenen Verfahrens zum Herstellen eines keramischen Vielschichtbauelements ermöglicht. Darüber hinaus hat die Haltevorrichtung den Vorteil, daß eine Vielzahl von Bauelementen mit denselben vorteilhaften Bedingungen der Sinteratmosphäre hergestellt werden können. Durch die Haltevorrichtung beziehungsweise durch die Oberfläche der Haltevorrichtung wird nämlich gewährleistet, daß das für den Sinterprozeß vorteilhafte Material, also das Sinterhilfsmittel, gleichmäßig in der Sinteratmosphäre und immer in der Nähe eines ungesinterten Bauelements vorhanden ist.

Die Oberfläche der erfindungsgemäßen Haltevorrichtung enthält ein Metall, dessen Redoxpotential wenigstens so groß ist, wie das Redoxpotential von Kupfer; d.h. des in den Innenelektroden des zu sinternden Bauelementes enthaltenen Metalls.

Das beschriebene Verfahren zur Herstellung eines keramischen Vielschichtbauelements kann also so ausgestaltet sein, daß Grundkörper verwendet werden, deren Innenelektroden Kupfer enthalten. Ebenso wird als Sinterhilfsmittel Kupfer verwendet. Die Verwendung von Kupfer als Material für die Innenelektroden hat den Vorteil, daß Kupfer einfach und billig zu beschaffen ist. Die Verwendung von Kupfer als Sinterhilfsmittel hat den Vorteil, daß Kupfer einfach und billig zu beschaffen ist und daß es auch gut zu verarbeiten ist, weswegen die Verwendung einer Haltevorrichtung aus Kupfer beim Betrieb des Verfahrens vorteilhaft ist.

Desweiteren ist ein Verfahren zur Herstellung eines keramischen Vielschichtbauelements vorteilhaft, bei dem die Sinteratmosphäre Sauerstoff enthält. Sauerstoff ist ein Gas, das bei vielen Sinterprozessen eingesetzt wird. Es wird benötigt, um der ungesinterten Keramik die vorteilhaften Eigenschaften der gesinterten Keramik zu verleihen. Darüber hinaus kann der in der Sinteratmosphäre enthaltene Sauerstoff leicht durch ein Sinterhilfsmittel aus Kupfer gebunden und auch wieder abgegeben werden.

Desweiteren ist ein Verfahren zur Herstellung eines keramischen Vielschichtbauelements vorteilhaft, bei dem die Sinteratmosphäre neben Sauerstoff eine Mischung aus Wasserstoff und Wasserdampf enthält. Durch das Gleichgewicht zwischen Wasserstoff und Wasserdampf kann einerseits die Gefahr der Oxidation der Innenelektroden wirksam vermindert werden. Andererseits kann dadurch der Sauerstoff-Partialdruck in der Sinteratmosphäre stabilisiert werden. Die Verwendung von Kupfer als Sinterhilfsmittel wirkt auch diesbezüglich vorteilhaft, da durch die Reaktion

4Cu + 2H₂O ⇄ 2Cu₂O + 2H₂ ⇄ 4Cu + O₂ + 2H₂

die Gleichgewichtsreaktion

2H₂O ⇄ O₂ + 2H₂

katalysiert und damit der Gleichgewichtszustand wesentlich schneller erreicht wird.

Als Keramikmaterial für das Bauelement kommt beispielsweise eine Keramik mit piezoelektrischem Effekt in Betracht. Dadurch können vorteilhafterweise piezoelektrische Aktoren hergestellt werden. Beispielsweise kommt es in Betracht, als Keramikmaterial Blei-Zirkonat-Titanat zu verwenden.

Darüber hinaus ist es vorteilhaft, für das Sinterhilfsmittel Kupfer einer Mindestreinheit zu verwenden, wie sie beispielsweise Elektrolytkupfer aufweist. In Betracht kommt beispielsweise sauerstofffreies Kupfer mit einer Reinheit > 99,9 %.

Die Haltevorrichtung besteht in einer vorteilhaften Ausführungsform aus zwei Teilen, die durch einen Spalt voneinander getrennt sind. Durch den Spalt kann einerseits erreicht werden, daß während des Sinterns entstehende Gase entweichen können und daß andererseits das Abdampfen von Blei aus dem Keramikmaterial kontrolliert wird.

Der Spalt zwischen den beiden Teilen eines Behälters beträgt vorteilhafterweise zwischen 0,5 und 10 mm in der Breite. Durch das Einhalten dieser Grenzen kann einerseits noch genug Gas aus den zu sinternden Bauelementen entweichen und andererseits wird verhindert, daß zuviel Blei abdampft.

Erfindungsgemäß weist die Haltevorrichtung einen gitterförmigen Einsatz in dem Behälter bzw. über der Grundplatte auf.

Bei der Verwendung von Kupfer kann es vorteilhaft sein, die Haltevorrichtung in Form eines Sektors eines Kreisrings auszuführen, wodurch das Volumen in Drehherdsinteröfen optimal ausgenutzt werden kann. Diese sektorförmigen Haltevorrichtungen können zu einem Kreisring ergänzt werden und das in einem Drehherdsinterofen zur Verfügung stehende Volumen optimal mit durch die Haltevorrichtung gehaltenen zu sinternden Bauelementen ausfüllen.

Im folgenden wird die Erfindung anhand von Ausführungsbeispielen und den dazugehörigen Figuren näher erläutert.
- Figur 1: zeigt beispielhaft ein keramisches Vielschichtbauelement in einem schematischen Querschnitt.
- Figur 2: zeigt beispielhaft eine Haltevorrichtung in einem schematischen Querschnitt.
- Figur 3: zeigt beispielhaft eine weitere Haltevorrichtung in einem schematischen Querschnitt.
- Figur 4: zeigt die Grundplatte der Haltevorrichtung aus Figur 3 in einer schematischen Draufsicht.
- Figur 5: zeigt einen beispielhaften Zeitverlauf der Sintertemperatur währen der Herstellung eines Bauelements.

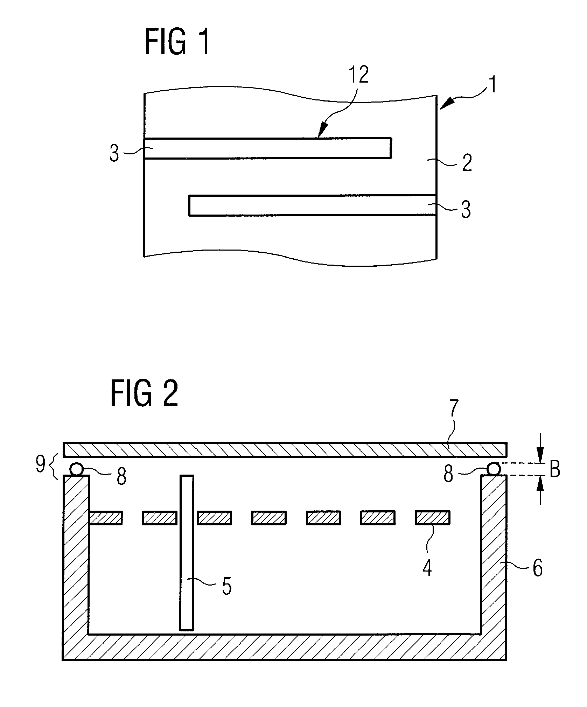

Figur 1 zeigt ein mit dem beispielhaften Verfahren hergestelltes keramisches Vielschichtbauelement mit einem Grundkörper 1, der eine gesinterte Keramik 2 enthält. Im Innern des Grundkörpers 1 sind Innenelektroden 3 enthalten, die eine metallhaltige Oberfläche 12 aufweisen und die in einer vorteilhaften Ausführungsform Kupfer enthalten oder sogar ganz aus Kupfer bestehen. Die Oberfläche 12 grenzt direkt an die Keramik 2.

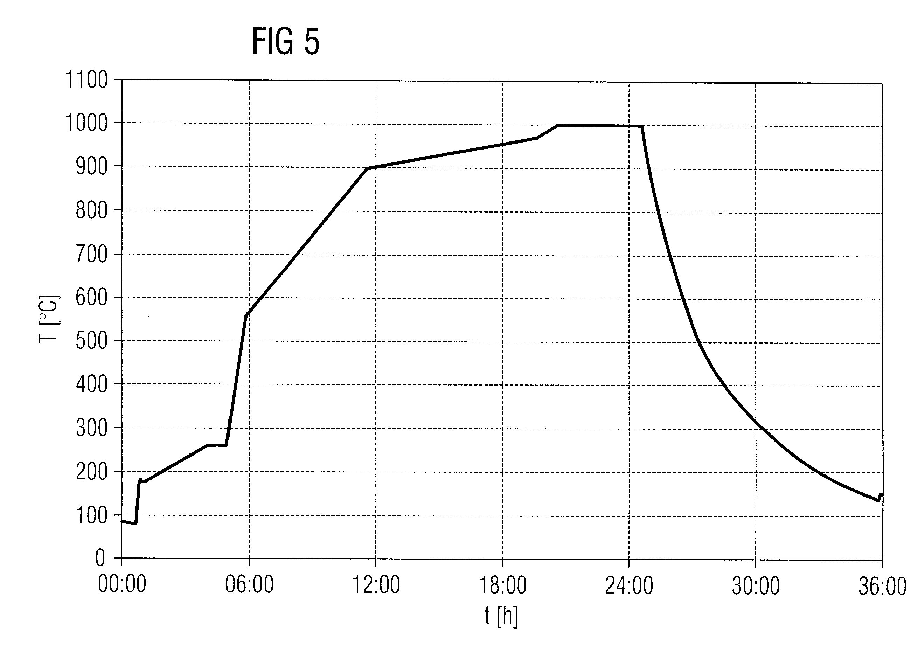

Beispielsweise kann das in Figur 1 dargestellte Bauelement ein Piezoaktor sein, mit einer Perovskitkeramik vom PZT-Typ Pb(ZrₓTi₁₋ₓ)O₃ und mit Innenelektroden aus Kupfer. Ein solcher Piezoaktor kann durch Sintern eines Stapels aus übereinanderliegenden Grünfolien hergestellt werden, wobei der Temperaturverlauf während des Sinterns dem in Figur 5 angegebenen Temperaturverlauf entspricht. In Figur 5 ist die Sintertemperatur T in Abhängigkeit von der Sinterzeit t angegeben. Die Sintertemperatur T hat ein Maximum bei 1005° C. Der Sauerstoffpartialdruck befindet sich in einem Bereich, in dem PbO aus der Keramik nicht mehr reduziert wird, was die Keramik stabilisiert, und in dem ferner Kupfer noch nicht oxidiert wird, was die Innenelektroden stabilisiert.

Figur 2 zeigt eine erfindungsgemäße Haltevorrichtung zur Verwendung bei dem Verfahren zur Herstellung eines keramischen Vielschichtbauelements, wobei die Haltevorrichtung einen Behälter 6 umfaßt, in dem ein gitterförmiger Einsatz 4 zur Aufnahme von ungesinterten Bauelementen 5 vorgesehen ist. Der Behälter 6 ist mit einem Deckel 7 verschließbar. Zwischen dem Behälter 6 und dem Deckel 7 sind Mittel 8 zum Vorsehen eines Spalts 9 zwischen dem Behälter 6 und dem Deckel 7 angeordnet. Diese Mittel 8 können beispielsweise Distanzelemente aus einer Keramik sein. Vorteilhafterweise beträgt die Breite B des Spalts 9 zwischen 0,5 und 10 mm.

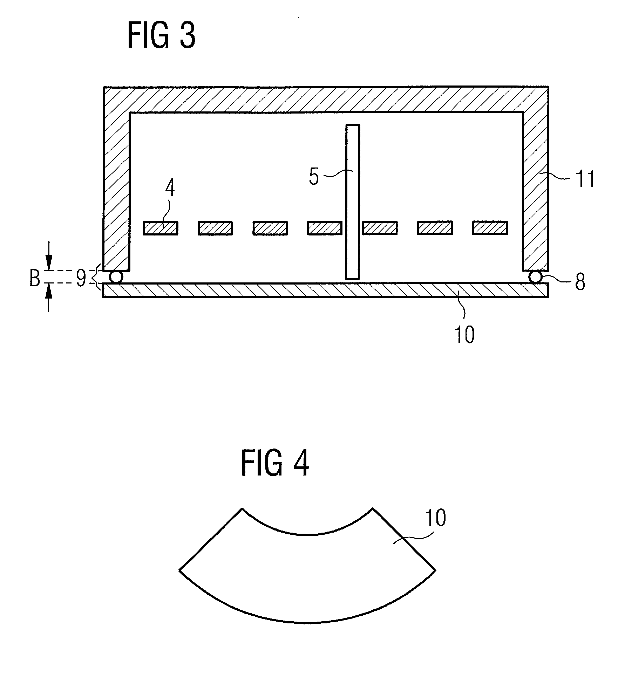

Figur 3 zeigt eine weitere Ausführungsform der Haltevorrichtung. Entsprechende Bezugszeichen bezeichnen dabei entsprechende Elemente aus Figur 2. Die Haltevorrichtung umfaßt eine Grundplatte 10, die von einer Kappe 11 abgedeckt ist. Innerhalb der Kappe 11 ist ein gitterförmiger Einsatz 4 zur Aufnahme von ungesinterten Bauelementen 5 vorgesehen.

Die Haltevorrichtung gemäß Figur 3 hat den Vorteil, daß bei Befestigung des gitterförmigen Einsatzes 4 an der Grundplatte 10 die Haltevorrichtung auch ohne die Kappe 11 betrieben werden kann und sich mithin auch zur Verwendung während der Entbinderung eignet. Die Grundplatte 10 kann vorteilhafterweise in der Form eines Sektors eines Kreisrings ausgeformt sein, wie aus Figur 4 ersichtlich. Dann ist es vorteilhaft, auch den gitterförmigen Einsatz 4 sowie die Kappe 11 in der Form eines Sektors eines Kreisrings auszuführen. Mehrere Grundplatten 10 beziehungsweise die dazugehörigen gitterförmigen Einsätze 4 und Kappen 11 können aneinandergereiht werden und sich zu einem Kreisring ergänzen.

Die vorliegende Erfindung beschränkt sich nicht auf Haltevorrichtungen für die Herstellung von Piezoaktoren, sondern ist auf alle keramischen Vielschichtbauelemente anwendbar, insbesondere auf solche, die kupferhaltige Innenelektroden aufweisen. Beispielsweise kommen auch Vielschichtkondensatoren in Betracht, die Innenelektroden aus Kupfer aufweisen und als Keramik BaNd₂Ti₄O₁₂ und Nd₂Ti₂O₇ sowie als Glasfritte ZnO - B₂O₃ - SiO₂ enthalten.

Es wird ein nicht beanspruchtes Verfahren zur Herstellung eines keramischen Vielschichtbauelements beschrieben,
wobei ein Grundkörper (1) enthaltend ungesinterte Keramik (2) und wenigstens eine metallhaltige Innenelektrode (3) in einer Sinteratmosphäre gesintert wird,
wobei in der Sinteratmosphäre ein Sinterhilfsmittel vorgesehen ist, das ein Metall enthält, dessen Redoxpotential wenigstens so groß ist, wie das Redoxpotential des in den Innenelektroden enthaltenen Metalls.

Alternativ wird ein nicht beanspruchtes Verfahren zur Herstellung eines keramischen Vielschichtbauelements beschrieben,
wobei ein Grundkörper (1) enthaltend ungesinterte Keramik (2) und wenigstens eine metallhaltige Innenelektrode (3) in einer Sinteratmosphäre gesintert wird,
wobei in der Sinteratmosphäre ein Sinterhilfsmittel vorgesehen ist, das ein in der Sinteratmosphäre enthaltenes Gas binden und wieder abgeben kann.

In beiden Verfahren kann als Sinterhilfsmittel Kupfer verwendet werden und die Innenelektroden (3) können Kupfer enthalten.

Die Sinteratmosphäre enthält vorzugsweise Sauerstoff. Die Sinteratmosphäre kann ein Gleichgewicht aus Wasserstoff und Wasserdampf enthalten.

Beschrieben ist eine nicht beanspruchte Keramik (2), die im gesinterten Zustand einen piezoelektrischen Effekt aufweist. Vorzugsweise wird als Keramik Blei-Zirkonat-Titanat verwendet.

Zudem wird ein nicht beanspruchtes keramisches Vielschichtbauelement enthaltend einen Grundkörper (1) mit einer gesinterten Keramik (2) und mit wenigstens einer Innenelektrode (3), die eine metallhaltige Oberfläche (12) aufweist, bei dem das Redoxpotential des in der Oberfläche (12) enthaltenen Metalls kleiner oder gleich dem Redoxpotential von Kupfer ist,
und bei dem die Oberfläche (12) direkt an die Keramik (2) angrenzt, beschrieben.

Vorzugsweise weist die Keramik des Bauelements einen piezoeelektrischen Effekt auf.

Vorzugsweise enthalten die Innenelektroden (3) des Bauelements Kupfer.

## Patentansprüche

1. Haltevorrichtung zur Verwendung beim Sintern eines keramischen Vielschichtbauelements mit kupferhaltigen Innenelektroden (3),
die zur Aufnahme einer Vielzahl von ungesinterten Bauelementen (5) geeignet ist und deren Oberfläche ein Metall enthält, dessen Redoxpotential wenigstens so groß ist wie das Redoxpotential von Kupfer, wobei
- die Haltevorrichtung einen Behälter (6) aufweist, **gekennzeichnet durch** einen gitterförmigen Einsatz (4) im Behälter (6), wobei der Behälter (6) mit einem Deckel (7) abdeckbar ist
und **durch**
- Mittel (8) zum Vorsehen eines Spalts (9) zwischen Behälter (6) und Deckel (7);
oder wobei
- die Haltevorrichtung eine Grundplatte (10) enthält,
**gekennzeichnet durch** einen über der Grundplatte (10) vorgesehenen gitterförmigen Einsatz (4),
wobei die
Grundplatte (10) mit einer Kappe (11) abdeckbar ist
und **durch**
- Mittel (8) zum Vorsehen eines Spalts (9) zwischen der Grundplatte (10) und der Kappe (11).

2. Haltevorrichtung nach Anspruch 1, zweite Alternative, die die Form eines Sektors eines Kreisrings aufweist.

3. Haltevorrichtung nach einem der vorhergehenden Ansprüche, bei der das Mittel (8) zum Einstellen eines Spalts (9) so ausgeführt ist, daß ein Spalt (9) mit einer Breite (B) zwischen 0,5 und 10 mm eingestellt werden kann.

## Claims

1. Retaining device for use when sintering a ceramic multilayer component with copper-containing inner electrodes (3),
which is suitable for receiving a multiplicity of unsintered components (5) and the surface of which contains a metal of which the redox potential is at least as great as the redox potential of copper, wherein the retaining device has a container (6), **characterized by** a grid-shaped insert (4) in the container (6), wherein the container (6) can be covered by a cover (7), and by means (8) for providing a gap (9) between the container (6) and the cover (7), or wherein the retaining device includes a baseplate (10), **characterized by** a grid-shaped insert (4) provided over the baseplate (10), wherein the baseplate (10) can be covered by a cap (11), and by means (8) for providing a gap (9) between the baseplate (10) and the cap (11).

2. Retaining device according to Claim 1, second alternative, which has the form of a sector of a circular ring.

3. Retaining device according to one of the preceding claims, in which the means (8) for setting a gap (9) is configured in such a way that a gap (9) with a width (B) of between 0.5 and 10 mm can be set.

## Revendications

1. Dispositif de retenue destiné à être utilisé lors du frittage d'un composant céramique multicouche comprenant des électrodes internes (3) contenant du cuivre,
lequel dispositif de retenue est approprié pour recevoir une pluralité d'éléments non frittés (5) et dont la surface contient un métal dont le potentiel d'oxydoréduction est au moins égal au potentiel d'oxydoréduction du cuivre,
le dispositif de retenue comprenant un contenant (6),
**caractérisé par** un insert (4) en forme de grille dans le contenant (6), le contenant (6) pouvant être recouvert par un couvercle (7), et par un moyen (8) pour prévoir un interstice (9) entre le contenant (6) et le couvercle (7) ; ou le dispositif de retenue comportant une plaque de base (10),
**caractérisé par** un insert (4) en forme de grille prévu au-dessus de la plaque de base (10), la plaque de base (10) pouvant être recouverte par une coiffe (11), et par un moyen (8) pour prévoir un interstice (9) entre la plaque de base (10) et la coiffe (11).

2. Dispositif de retenue selon la revendication 1, deuxième variante, qui présente la forme d'un secteur d'un anneau circulaire.

3. Dispositif de retenue selon l'une quelconque des revendications précédentes, dans lequel le moyen (8) pour régler un interstice (9) est réalisé de telle sorte qu'un interstice (9) présentant une largeur (B) entre 0,5 et 10 mm puisse être réglé.
